# EUROPEAN PATENT APPLICATION

(11) **EP 4 685 682 A1**
(43) Date of publication of application: **28.01.2026**
(21) Application number: 24190882.1
(22) Date of filing: 25.07.2024
(51) Int. Cl.: G06F 30/15, B63B 79/00, B63B 79/10, B63B 79/20, G06F 30/20, G06F 30/27

(54) **METHOD, COMPUTER PROGRAM AND COMPUTER PROGRAM PRODUCT FOR THE DETERMINING OF A WIND MODEL OF A VESSEL AS WELL AS A WIND MODEL DETERMINING DEVICE AND VESSEL COMPRISING A WIND MODEL DETERMINING DEVICE**

(71) Applicant: ABB SCHWEIZ AG, 5400 Baden (CH)
(72) Inventor: LINDKVIST, Rickard, 725 91 Västerås (SE); LINDER, Jonas, 464 93 Mellerud (SE)
(74) Representative: Kransell & Wennborg KB

(57) **Abstract**

The invention relates to a method. computer program and computer program product for the determining of a wind model of a vessel as well as to a wind model determining device and vessel comprising such a wind model determining device. The wind model determining device (10) obtains at least one present sensor measurement of a vessel (26B) when it is carrying a present visible cargo (40, 42), and determines at least a part of a wind model of the vessel (26B) based on the at least one present sensor measurement.

## Description

### TECHNICAL FIELD

The invention relates to a method, computer program and computer program product for determining a wind model of a vessel as well as to a wind model determining device and vessel comprising such a wind model determining device.

### BACKGROUND

The wind may have a serious impact on a vessel. This impact may need to be compensated if a vessel is to stay on course. Another situation when the impact may need to be considered is if a sufficient safety margin is needed to both static and moving obstacles for a contemplated route.

One way of determining the impact of the wind is to use a wind model. A wind model describes the effect on the vessel, for instance, by defining the area of the vessel that faces the wind and using this to determine the forces acting on the vessel.

For many vessels a wind model may be easy to determine. It may in many cases be determined based on the vessel structure or vessel layout, which may be known.

However, in some cases, for example, when a vessel has a cargo, the impact of the wind may vary significantly. A vessel which is container or cargo vessel or a car ferry may have visible cargo objects on at least one exterior surface of the vessel. Furthermore, the number and sizes of the cargo objects may vary. Also the weight of the cargo objects may vary.

This means that knowledge of the vessel structure may not be sufficient for determining the wind model of a vessel.

There is thus a need for an improvement in the determining of the wind model of a vessel.

### SUMMARY

One object of the invention is therefore to allow an improved determining of a wind model of a vessel to be made.

This object is according to a first aspect achieved by a method for the determining of a wind model of a vessel, the method being performed by a wind model determining device and comprising:
obtaining at least one present sensor measurement of the vessel when it is carrying a present visible cargo, and
determining at least a part of a wind model of the vessel based on the at least one present sensor measurement.

The object is according to a second aspect achieved through a wind model determining device comprising:
a processor operative to:
obtain at least one present sensor measurement of a vessel when it is carrying a present visible cargo, and
determine at least a part of a wind model of the vessel based on the at least one present sensor measurement.

The object is according to a third aspect achieved by a vessel comprising the wind model determining device according to the second aspect.

The object is according to a fourth aspect achieved through a computer program for the determining of a wind model of a vessel, the computer program comprising computer program code which when run by a processor causes the processor to:
obtain at least one present sensor measurement of the vessel when it is carrying a present visible cargo, and
determine at least a part of a wind model of the vessel based on the at least one present sensor measurement.

The object is according to a fifth aspect achieved through a computer program product for the determining of a wind model of a vessel, the computer program product comprising a data carrier with the computer program according to the fourth aspect.

The determining of at least a part of a wind model of the vessel may comprise determining at least one wind area of the vessel.

The determining of at least one wind area may comprise determining a wind area for use in determining a wind model using a present wind direction and present wind speed.

The determining of at least one wind area may comprise determining a number of wind areas for a number of different wind directions.

The determining of at least a part of a wind model may comprise determining of at least one wind model.

The determining of the wind model may comprise determining of the wind model based on the determined wind area for a present wind area and present wind speed.

The determining of at least one wind model may comprise determining a number of wind models for a number of different wind directions and wind speeds.

The at least one sensor measurement may be an image captured by a camera or a Lidar. The at least one sensor measurement may alternatively be a draft measurement made by a draft sensor.

The vessel may be a container or cargo vessel. It may also be a car ferry. It might also be any other type of vessel that has varying wind area due to changing cargo or moving equipment on the vessel.

According to a first variation of the first aspect, the method further comprises obtaining data related to the vessel without the present visible cargo. In this case, the determining of at least a part of a wind model of the vessel is also based on the data related to the vessel without the present visible cargo.

According to a corresponding variation of the second aspect, the processor is further operative to obtain data related to the vessel without the present visible cargo. In this case, the determining of at least a part of a wind model of the vessel is also based on the data related to the vessel without the present visible cargo.

The data related to the vessel without the present visible cargo may comprise data about the vessel structure. Alternatively or instead, the data related to the vessel without the present visible cargo may comprise a wind model contribution of the vessel without the present visible cargo.

According to a further variation of the first aspect, the method further comprises obtaining present cargo data about the present cargo from a cargo model of a load information management system of the vessel. In this case the determining of at least a part of the wind model is based also on the present cargo data of the cargo model.

According to a corresponding variation of the second aspect, the processor is further operative to obtain present cargo data about the present cargo from a cargo model of a load information management system of the vessel. In this case, the determining of at least a part of the wind model is based also on the present cargo data of the cargo model

The at least one present measurement may be at least one present image of the vessel.

According to another variation of the first aspect, the method further comprises analysing the at least one present image in order to determine individual cargo objects and a contribution of these individual cargo objects to the wind model of the vessel.

According to a corresponding variation of the second aspect, the processor is further operative to analyse the at least one present image in order to determine individual cargo objects and a contribution of these individual cargo objects to the wind model of the vessel.

In this case, the determining of at least a part of the wind model may additionally comprise combining the contribution of the individual cargo objects with the wind model contribution of the vessel without the present visible cargo.

According to yet another variation of the first aspect, the method further comprises obtaining at least one draft sensor measurement. In this case the determining of at least a part of the wind model may be based also on the at least one draft sensor measurement.

According to a corresponding variation of the second aspect, the processor is further operative to obtain at least one draft sensor measurement. In this case the determining of at least a part of the wind model may be based also on the at least one draft sensor measurement.

The data related to the vessel without the present visible cargo may be at least one previous image of the vessel.

According to another variation of the first aspect, the method in this case further comprises comparing the at least one present image with the at least one previous image of the vessel and the determining of at least a part of the wind model is based on the comparison of the images.

According to a corresponding variation of the second aspect, the processor is further operative to compare the at least one present image with the at least one previous image of the vessel. The determining of at least a part of the wind model is in this case based on the comparison of the images.

The at least one previous image may comprise an image of the vessel with a known projected area and a known cargo. Alternatively, the at least one previous image may comprise an image for which there has been detected a vessel behaviour caused by a known wind force acting on the vessel.

As an alternative to being an image, the at least one present sensor measurement may be at least one present draft measurement of the vessel. In this case, the data related to the vessel without the present visible cargo may additionally comprise data about the vessel structure.

A wind model defines forces that act on a vessel, which forces may be calculated based on a wind area, where the wind area is an area of the vessel that faces the wind. This area facing the wind may also be called projected area.

It should be emphasized that the term "comprises/comprising" when used in this specification is taken to specify the presence of stated features, integers, steps or components, but does not preclude the presence or addition of one or more other features, integers, steps, components or groups thereof.

### BRIEF DESCRIPTION OF THE DRAWINGS

The invention will now be described in more detail in relation to the enclosed drawings, in which:
fig. 1 schematically shows a first way of realizing a wind model determining device,
fig. 2 shows a computer program product in the form of a CD ROM with computer program code used to implement a wind model determining function of the wind model determining device,
fig. 3 schematically shows a land installation comprising the wind model determining device,
fig. 4 schematically shows a vessel comprising the wind model determining device,
fig. 5 shows a flow chart of a number of method steps in a first embodiment of a method of determining a wind model of a vessel,
fig. 6 shows a flow chart of a number of method steps in a second embodiment of a method of determining a wind model of a vessel,
fig. 7 shows a flow chart of a number of method steps in a third embodiment of a method of determining a wind model of a vessel,
fig. 8 shows a flow chart of a number of method steps in a fourth embodiment of a method of determining a wind model of a vessel,
fig. 9 shows a flow chart of a number of method steps in a fifth embodiment of a method of determining a wind model of a vessel, and
fig. 10 shows a flow chart of a number of method steps in a sixth embodiment of a method of determining a wind model of a vessel.

### DETAILED DESCRIPTION

In the following description, for purposes of explanation and not limitation, specific details are set forth such as particular architectures, interfaces, techniques, etc. in order to provide a thorough understanding of the invention. However, it will be apparent to those skilled in the art that the invention may be practiced in other embodiments that depart from these specific details. In other instances, detailed descriptions of well-known devices, circuits and methods are omitted so as not to obscure the description of the invention with unnecessary detail.

The invention is generally directed towards determining the wind model of a vessel, which may be of interest in the control of the vessel. As is known, a wind area is a component of a wind model of a vessel, which component is used to calculate forces caused by the wind that act on the vessel. The determining of a wind model is for instance described in "Handbook of Marine Craft Hydrodynamics and motion control", by T.I. Fossen, 2011, which is herein incorporated by reference.

The wind area is an area of the vessel that faces the wind direction. If the vessel carries a visible cargo, it is clear that also this cargo contributes to the wind area and thereby also to the forces acting on the vessel.

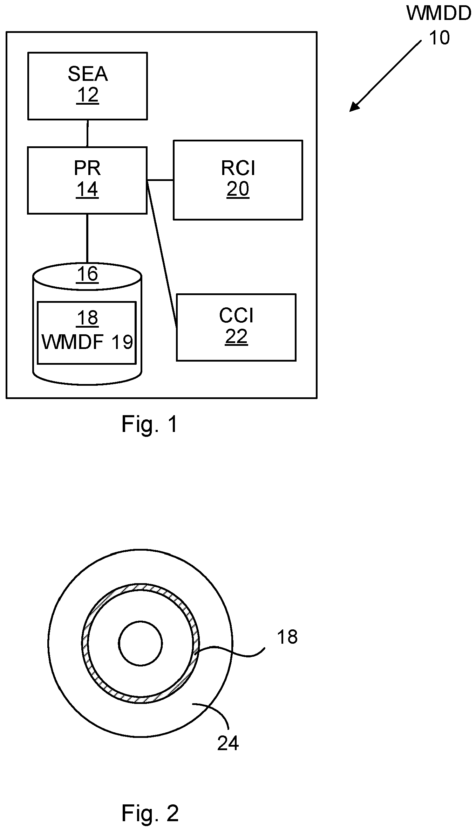

Fig. 1 schematically shows one realization of a wind model determining device WMDD 10. Optionally, the wind model determining device 10 comprises at least one sensor. In this case it comprises a first sensor SEA 12, which may be a Lidar (Light Detection And Ranging), a camera or any other sensor that can be used to detect changes to a wind model. There is also a processor PR 14 and a data storage 16 with a computer program 18 comprising computer program instructions that, when executed by the processor 14, implements a wind model determining function WMDF 19.

There is also a first communication interface, here realized as a radio communication interface RCI 20 and a second communication interface, here realized as a computer communication interface CCI 22. The radio communication interface 20 is also a transmitter that transmits radio signals. It should be realized that it is possible that the wind model determining device 10 only comprises the radio communication interface and not the computer communication interface or vice versa. The communication interface could also be wired rather than wireless.

It should also be realized that the sensor does not need to be a part of the wind model determining device. It is sufficient if the wind model determining device has access to sensor measurements from the sensor. The sensor may for instance be provided on a vessel for which the wind model is to be determined and the wind model determining device may obtain sensor measurements or sensor data through communicating with the vessel. The sensor may also be placed in a land installation at a passage that a vessel, for which a wind model is to be determined, passes. As another alternative a sensor may be provided in a drone that is to fly along the vessel for which the wind model is to be determined. Alternatively, a sensor might be provided on another vessel. Also, in these cases the wind model determining device may communicate with the external sensor. Naturally, any combination of the above sensor locations, or other arrangements, can be used.

In some cases, the wind model determining device 10 may also be wholly or partly implemented in the cloud or employ the cloud for processing. The wind model determining function 19 may thus be wholly or in parts implemented on a computing resource in a data centre, such as on a server blade, where it is additionally possible that the wind model determining function 19 is being assigned to the computing resource by a function assigning unit. Alternatively, the wind model determining device 10 may connect to the cloud and request processing and receive the result of the processing therefrom, which processing may involve determining one or more wind models or parts of wind models.

As yet another alternative, it is possible that the wind model determining device 10 with sensor is a part of the land installation or provided in the drone with sensor.

The wind model determining device 10 may thus comprise a processor 14 with associated program memory 16 including a computer program 18 with computer program code for implementing the wind model determining function 19.

A computer program may also be provided via a computer program product, for instance in the form of a non-transitory computer readable storage medium or data carrier, like a CD ROM, a memory stick or memory card, carrying such a computer program with the computer program code, which will implement the wind model determining function when being loaded into a processor. One such computer program product in the form of a CD ROM 24 with the above-mentioned computer program 18 comprising computer program code is schematically shown in fig. 2.

As can be seen above, there are a number of locations that are possible for the wind model determining device 10.

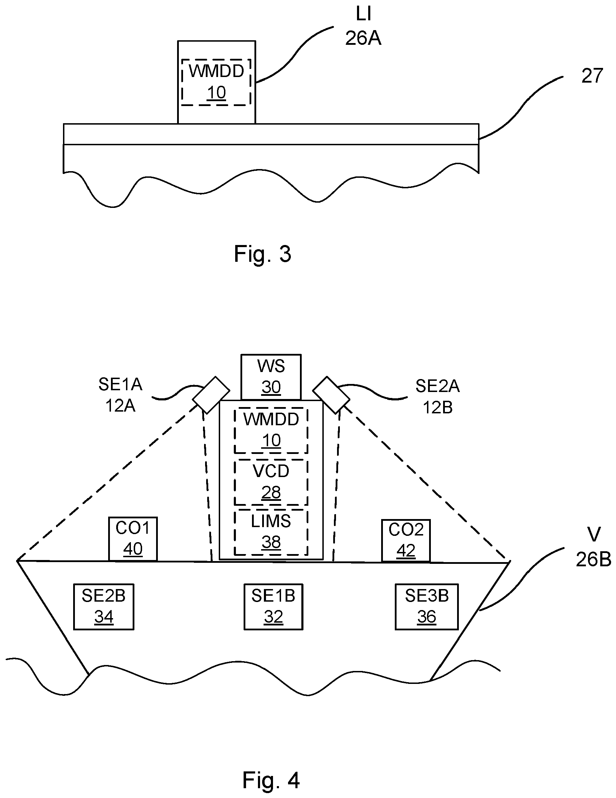

As was mentioned above, one such location is a land installation. Fig. 3 shows a land installation LI 26A comprising the wind model determining device WMDD 10. In the example, the land installation 26A is provided at a point which a vessel for which a wind model is to be determined is to pass, such as on a quay 27 of a harbour or port. However, it should be realized that other locations are possible, such as on islands close to navigational paths, such as fairways, that the vessel is to pass.

As was mentioned earlier, the wind model determining device may also be provided in a drone (not shown) or on another vessel.

As was also mentioned earlier, the wind model determining device may also be provided on a vessel such as a cargo container vessel or a car ferry for which the wind model is to be determined. Fig. 4 shows a vessel 26B that comprises the wind model determining device 10.

Here the vessel 26B also comprises at least one image sensor. As an example, there is a first image sensor SE1A 12A and a second image sensor SE2A 12B. There is also at least one draft sensor and in the present example there is a first draft sensor SE1B 32, a second draft sensor SE2B 34 and a third draft sensor SE3B 36 all provided on the vessel hull. The first draft sensor 32 is provided at a lateral mid position of the hull midway between the fore and aft of the vessel 26B, while the second draft sensor 34 may be a fore draft sensor and the third draft sensor 36 may be an aft draft sensor. It should here be realized that the vessel may only be equipped with the image sensors or draft sensors. The vessel 26B also comprises a wind sensor WS 30.

There is also a vessel control device VCD 28 implementing a vessel control function and an optional load information management system 38.

The vessel is a vessel holding a cargo, such as a cargo comprising vehicles or containers, which cargo is visible and placed on an external surface of the vessel 26B such as on a car deck or container deck. Two cargo objects are shown in the figure, a first cargo object CO1 40 and a second cargo object CO2 42. In the present example, the first image sensor 12A covers a part of an upper deck where the first cargo object 40 is provided and the second image sensor, covers a second part of the upper deck where the second cargo object 42 is provided. It should be realized that as an alternative it is possible with only one image sensor that covers the whole of the upper deck. It is also possible with two image sensors covering the same part of the deck in order to more easily obtain a 3D representation of cargo objects or to cover blind spots. It should also be realized that the number of cargo objects can be varied. Two are only given as an example to describe the various aspects. Typically, the cargo will comprise many more cargo objects. It should also be realized that the objects might comprise equipment attached to the vessel, such as, cranes or jack-up legs.

As was mentioned earlier the impact of wind on a vessel can be determined using a wind model, where a wind model defines the forces acting on the vessel due to the wind based on the wind area.

Aspects of the present disclosure are directed towards using sensors, e.g. Lidars, cameras and/or draft sensors, to estimate the vessel area that is affected by the wind. A present wind area is dependent on the wind direction as well as the size and shape of the vessel with visible cargo. Such a wind area is also denoted a projected area of the vessel, which projected area is dependent on the wind direction. The environmental force exerted by the wind on the vessel is therefore dependent on a present wind area, a present wind direction and a present wind speed. This environmental force impacts the vessel motion, which influences the vessel motion control and how to operate it in a safe and efficient way. The variation in projected area depends on the type of vessel. If the vessel has a more or less static size and shape, e.g. cruise ferry, the projected area for different wind directions and potentially other factors, such as draft, list, etc., can be calculated once during the design phase.

However, for other vessel types, for example, small road ferries, supply ships or also to some extent container ships, the projected area cannot be calculated only using the static model developed during the design phase. For these applications, the projected area must be estimated/calculated considering the present cargo.

A wind model is thus not that easy to determine when the vessel has a visible cargo that may vary from time to time, where a visible cargo may be a cargo on an exterior surface of the vessel, such as on an upper deck of the vessel.

Aspects of the present disclosure are directed towards determining the wind model for such a vessel.

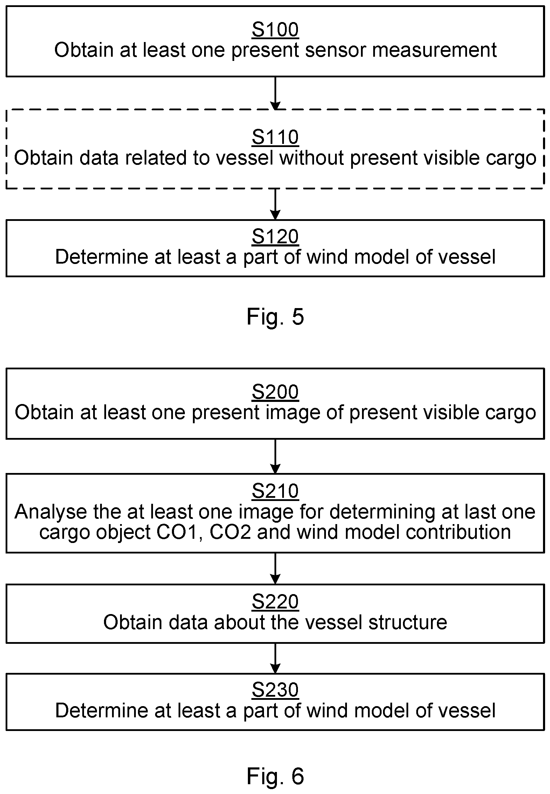

How this can be done will now be described with reference also being made to fig. 5, which shows a flow chart of a number of method steps in a first embodiment of a method for determining a wind model of a vessel.

The method is carried out by the wind model determining function 19 of the wind model determining device 10.

The method may start by the wind model determining function 19 of the wind model determining device 10 obtaining at least one present sensor measurement of the vessel when it is carrying a present visible cargo, S100, where in the example of fig. 4 the present visible cargo comprises the first and second cargo objects 40, 42. The at least one present sensor measurement may be a present captured image of the cargo by the image sensors 12A, 12B or by an image sensor in the land installation 26A or in a drone. The image may comprise image or Lidar data captured by a camera or a Lidar. Alternatively, the at least one sensor measurement may comprise one or more or draft measurements made by a draft sensor, for instance draft measurements from the draft sensors 32, 34, 36.

Optionally, the wind model determining function of the wind model determining device 10 also obtains data related to the vessel without the present visible cargo 40, 42, S110.

For the case that the at least one sensor measurement is a captured image, the data may be a number of different things.

The data may for instance comprise at least one previous image.

The at least one previous image may comprise an image for which there has been detected a vessel behaviour caused by a known wind force acting on the vessel 26B. Alternatively, the at least one previous image may comprise an image of the vessel 26B with a known projected area and a known cargo. The at least one previous image may in this case further be a designed, simulated or model image of different cargo sizes or different trims.

The at least one present image may thus be compared with at least one previous image, for instance an image with the same cargo. Alternatively, the data may comprise an image associated with a wind model of a previous cargo or an image with a known previous trim.

Alternatively or in addition to images, the data may comprise data about the vessel structure.

Additionally or instead, the data may comprise data about a known wind model without the present visible cargo.

It is furthermore possible that also present cargo data is obtained, such as present cargo data from cargo type and/or cargo position/direction or cargo data about a present cargo from the load information management system, such as from a cargo model of the load information management system.

It is also possible that the additional data comprises calibration information so that the first image can be used to determine the wind area.

If the present sensor data comprises sensor data from at least one draft sensor, it is additionally possible to use also this sensor data.

Thereafter, the wind model determining device determines at least a part of a present wind model, such as, the projected wind area, of the vessel based on the at least one present sensor measurement and optionally also based on the data related to the vessel without the present visible cargo, S120. As another option the at least a part of the present wind model may be determined also based on the present cargo data.

The determining of at least a part of a wind model may comprise determining a wind model for a present direction and speed of a wind that hits the vessel. Alternatively, the determining of at least a part of a wind model may involve determining a number of wind areas for different possible directions with which a wind may hit the vessel A wind area for a present wind direction can then be used together with a corresponding present wind speed for determining a present wind model. As yet another alternative, the determining of at least a part of a wind model may involve determining a number of wind models for different possible directions and wind speeds with which a wind may hit the vessel and using one that corresponds to the wind direction and wind speed of a wind that hits the vessel.

If the sensor measurement is an image and only the at least one present sensor measurement is used, a wind model may be determined based on a determination of a projected area of the vessel with the visible cargo in the captured image of the vessel, such as in an image captured by a drone or in a land installation or in one at least one image captured by one or more image sensors provided on the vessel, which at least one image sensor may cover the visible cargo and one or more parts of the vessel that are located above the sea level. The at least one image may thus be analysed in order to determine the projected area or wind area of the vessel with visible cargo.

For the use of present and previous images the determining may be based on a comparing of the images with each other.

When the at least one previous image comprises an image of the vessel with a known projected area and a known cargo, the determining of the wind model may be based on a difference between the images. When the at least one previous image comprises an image for which there has been detected a vessel behaviour caused by a known wind force acting on the vessel, the determining of the wind model may be based on a similarity between the images.

In case the data of the vessel without present cargo comprises the structure of the vessel, a determining of the present wind model may be based on determining a contribution to the present wind model from the vessel structure and a contribution to the present wind model from the present image.

In this case, the determining of the contribution from the present image may additionally comprise determining cargo objects in the image and the contribution to the wind model made by these cargo objects.

In case cargo data is obtained from a cargo model, the determining of the wind model may also be based on the present cargo data of the cargo model. For instance, this data may assist in the determining of cargo objects. Cargo data may also be used in determining how much and which parts of the vessel structure is to contribute to the present wind model.

The determining of at least a part of the wind model may thus comprise analysing the at least one present image in order to determine individual cargo objects and a contribution of these individual cargo objects to the wind model of the vessel.

Also draft sensor data may be used in determining how much and what parts of the vessel structure that contributes to the total wind model.

In case the present sensor data comprises one or more draft measurements, the determining of the present wind model may involve determining a contribution of the present cargo to the present wind model based on the cargo data and the at least one draft measurement and a contribution to the wind model without the present cargo from the draft measurement and knowledge of the vessel structure.

The one or more wind models may then be used in the operation of the vessel. If the wind model determining device 10 does not have access to the wind sensor 30, then several different wind areas may be determined, for instance one for every possible wind direction, and supplied to the vessel control device 28. The vessel control device 28 may then select and use one of the wind areas that corresponds to a present wind direction sensed be the wind sensor 30 and use together with a corresponding present wind speed to determine a present wind model. Thus, the wind model determining device 10 can determine wind areas for a few different directions that the vessel control device 28 may use to interpolate between depending on the direction sensed by the wind sensor 30. As another alternative, the wind model determining device may determine several different wind models for different wind directions and speeds and supply to the vessel control device 28. The vessel control device 28 may then select and use one of the wind models that corresponds to a present wind direction and speed sensed be the wind sensor 30. However, if the wind model determining device 10 has access to the wind sensor 30, it may obtain a present wind direction and speed from this sensor 30 and determine and provide a single wind model for this wind direction to the vessel control device 28..

A wind model can be used in the control of the vessel 26B, for instance when the vessel control device 28 controls the propulsion of the vessel. The propulsion of the vessel may be controlled so that the effect on the vessel by the wind is counteracted, which effect may be determined based on the wind model. It can also be used to increase the safety margin in the direction of the wind in case the vessel propulsion is lost or crippled.

A second embodiment will now be described with reference being made to fig. 6, which shows a flow chart of a number of method steps in the method of determining the wind model of the vessel.

In this embodiment the present sensor data comprises at least one image captured by the at least one image sensor 12A, 12B on the vessel 26B, in the land installation26A or in the drone.

The method may start with the wind model determining device 10 obtaining at least one present image of the present visible cargo, S200, which at least one present image may be captured by the land installation 26B, a drone or the image sensors 12A, 12B on the vessel 26B. Furthermore, it is possible that the image sensors have default camera angles and that these are used. Alternatively, the camera angles may be such that the objects are captured from one or more angles at which the wind hits or is expected to hit the vessel 26B.

Thereafter the wind model determining device 10 analyses the at least one image for determining at least one visible cargo object and wind model contribution, S210.

If the at least one image is an image of the deck, the determining may comprise identifying objects on the deck, such as containers or vehicles and the area that they present in a wind direction. If there is more than one image, it may be possible to determine a three-dimensional model of the cargo objects and determine the area they present in one or more wind directions based on these models. The area that the combined cargo objects present in a wind direction may then be determined as the wind model contribution of the cargo objects in this wind direction, i.e. the contribution to the wind model that the cargo objects make. In the example of fig. 4 there are two cargo objects, a first and a second cargo object 40, 42. The combined areas of these objects in the or all possible wind directions would in this case be the wind model contributions of the visible cargo.

The determining of the wind model may thus comprise analysing the at least one present image in order to determine individual cargo objects and a contribution of these individual cargo objects to the wind model of the vessel.

The wind model determining device may also obtain data about the vessel structure, S220, for instance in the form of a three-dimensional model of the vessel. The area that the vessel presents in one or more directions of the wind may then be determined based on the model. The area may also be based on knowledge about the weight of the vessel and/or knowledge about or estimation of the weight of the cargo objects. The weight data may be used together with the vessel structure data to estimate the draft of the vessel, i.e. how much of the vessel that is above sea level and therefore how much of the vessel that is affect by the wind.

Thereafter the wind model determining device determines at least a part of a wind model of the vessel, which part is determined based on the area above water that the vessels with cargo objects present in a direction of the wind.

It is in this case also possible that the wind model determining device 10 receives a wind measurement from the wind sensor 30 and determines the wind model for the wind direction and wind speed of this measurement. Alternatively, a number of possible wind areas may be determined for different possible wind directions. These different wind areas may then be stored in a memory or supplied to the vessel control device 28. As another alternative a number of possible wind models may be determined for different possible wind directions and speeds. These different wind models may then be stored in a memory or supplied to the vessel control device 28.

A wind model can then be used in the control of the vessel, for instance when the vessel control device 28 controls the propulsion of the vessel, where a wind model may be previously determined by the wind model determining device 10 or the vessel control device 28 uses a previously determined wind area associated with a present wind direction for determining a present wind model based on the present wind direction and a present wind speed. The propulsion of the vessel may then be controlled so that the effect on the vessel by the wind is counteracted, which effect may be determined based on the wind model.

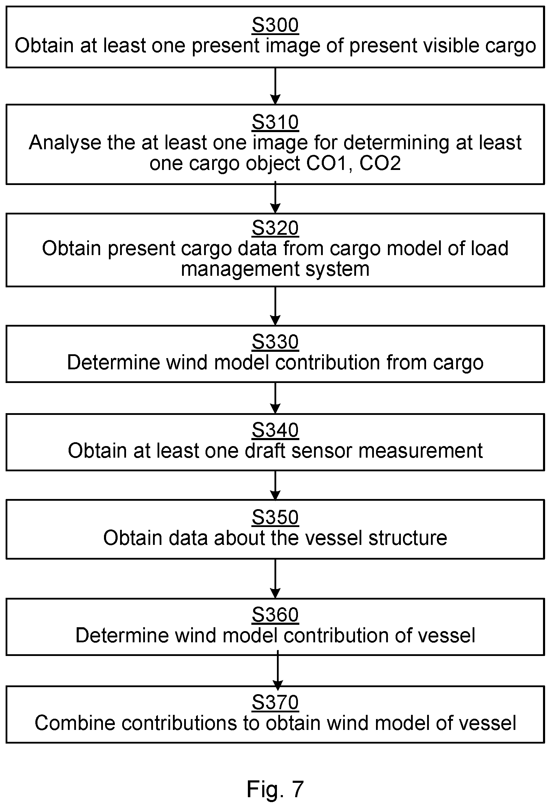

A third embodiment will now be described with reference being made to fig. 4 and 7.

In this embodiment the present sensor data again comprises at least one image captured by the at least one image sensor 12A, 12B. The vessel 26B also has a load information management system LIMS 38 that is used.

The method may start with the wind model determining device 10 obtaining at least one present image of the present visible cargo, S300, which at least one present image may be captured by a land installation, a drone or the image sensors on the vessel. Furthermore, it is possible that the image sensors have default camera angles and that these are used. However, as an alternative it is possible that angles are used that are based on the wind direction. The camera angels may for instance be such that the objects are captured from the angle at which the wind hits the vessel.

Thereafter the wind model determining device 10 analyses the at least one image for determining at least one visible cargo object.

The wind model determining device 10 may also obtain present cargo data from the cargo model of the load information management system 38, which cargo data may include data of the number cargo objects that the vessel carries as well as perhaps their shapes and sizes. The cargo data may also comprise data about the weight of the cargo objects. However, the weight is not used in this step.

Thereafter the wind model device determines at least one wind model contribution from the cargo, S330, i.e. the contribution to a total wind model of the vessel made by the visible cargo 40, 42. It may determine a contribution from a cargo for one wind direction or a number of contributions for a number of wind directions, such as all possible wind directions.

For a present direction of the wind, such a determination may be made based on the areas of the cargo objects that have been determined based on the at least one image and the areas of the cargo objects that have been determined based on the present cargo data.

It should here be realized that it is possible to determine the wind model contribution from the cargo without using cargo data from the cargo model.

If the at least one image is an image of the deck, the determining may comprise identifying objects on the deck, such as containers and the area that they present in the wind direction. If there is more than one image, it may be possible to determine three-dimensional models of the cargo objects and determine the area they present in a wind direction based on these models. It is also possible to use information such as sizes of containers to determine a three-dimensional model from a single image. Also the cargo data, including data about a number of cargo objects as well as perhaps their shapes and sizes may be used to determine the area of these objects in the wind direction and/or in the determined model.

The estimations of the cargo object areas are then used to form the one or more wind model contributions from the cargo. The area that the cargo objects present in a wind direction may then be determined as the wind model contribution of the cargo objects, i.e. the contribution to the wind model that the cargo objects make.

The wind model determining device may also obtain at least one draft sensor measurement from the draft sensors 32, 34, 36, S340, including data about how much and what parts of the vessel is above and below the water level. The wind model determining device may also obtain data about the vessel structure, S350, for instance in the form of a three-dimensional model of the vessel or projection of the vessel in several planes, such as front view, sideview and aft views. The area that the vessel without cargo presents in the one or more directions of the wind may then be determined based on the model. The draft measurements may then be used to determine what parts of the vessel are above the water level, i.e. what parts are affected by the wind. The part or parts above water level may also or instead be determined based on knowledge about the weight of the vessel and/or knowledge about or estimation of the weight of the cargo objects, for instance from cargo data from the cargo model.

Thereafter the wind model determining device 10 determines the wind model contribution of the vessel for one or more wind directions, S360, where such a wind model contribution is the area contribution of the vessel 26B to the wind model without (the area contribution from) the visible cargo, which wind model contribution of the vessel is determined based on the area above water that the vessel presents in the wind direction. This can be determined based on the draft sensor measurements and the knowledge about the vessel structure.

The two contributions are then combined for obtaining a wind model of the vessel, S370, More particularly the wind areas of the two contributions may be combined and then the wind area of the combination may be used together with wind data to obtain the wind model.

The wind model can then be used in the control of the vessel, for instance when controlling the propulsion of the vessel. Alternatively, it can be used in a vessel advisory system to inform the crew about the potential effects of the wind.

A wind model may be determined in real-time for a certain wind direction and wind speed based on a request from the vessel control device or determined in advance together with a number of other possible wind models and stored in a wind model library. As yet another alternative a number of wind areas may be stored in the library and used for determining a wind model for a present wind direction and wind speed.

The propulsion of the vessel may then be controlled so that the effect on the vessel by the wind is counteracted, which effect is determined based on the wind model.

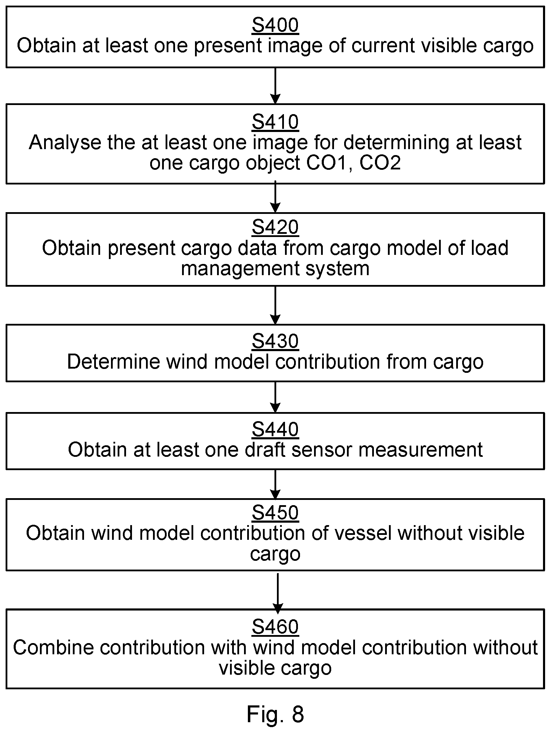

A fourth embodiment will now be described with reference being made to fig. 8.

In this embodiment the present sensor data again comprises at least one image captured by the at least one image sensor 12A, 12B. The vessel 26B also has the load information management system 38 that is used. For this reason, it may be preferable that the wind model determination device 10 is provided in the vessel 26B. However, as an alternative the calculations can be made in the cloud or similar. Furthermore, in this case there is a pre-existing wind model for the vessel without cargo.

The method may again start with the wind model determining device 10 obtaining at least one present image of the present visible cargo, S400, which may be obtained with default camera angles or angles that are based on the wind direction. The camera angles may for instance be such that the objects are captured from the angle at which the wind hits the vessel.

Thereafter the wind model determining device 10 analyses the at least one image for determining at least one visible cargo object 40, 42, S410.

The wind model determining device 10 also obtains present cargo data from the cargo model of the load information management system 38, S420, which cargo data may again include data of the number of cargo objects that the vessel carries as well as perhaps their shapes, sizes, weights and locations on the vessel 26B.

Thereafter the wind model determining device 10 determines one or more wind model contributions from the cargo, S430, i.e. contributions to total wind models of the vessel made by the visible cargo for the one or more possible wind directions.

Such a determination is again made based on the areas of the cargo objects in the wind direction that have been determined based on the at least one image and on the present cargo data.

It should here be realized that it is possible to determine the wind model contribution of the cargo without cargo data from the cargo model.

The determining of the wind model may thus comprise analysing the at least one present image in order to determine individual cargo objects and a contribution of these individual cargo objects to the wind model of the vessel.

The wind model determining device may also obtain at least one draft sensor measurement from the draft sensors 32, 34, 36, S440. The wind model determining device 10 may also obtain one or more wind models of the vessel without visible cargo, S450, which may be one or more preexisting wind models of the vessel taken from a wind model library. The draft measurements may then be used to determine what parts of the vessel are above the water level, i.e. what parts of the wind area that are above the water. Alternatively, it is possible to determine the part or parts of the vessel that are above the water level only using cargo data from the cargo model.

The parts of the wind area without visible cargo that are deemed to be above the water are then considered to be the wind model contribution of the vessel without the visible cargo.

Thereafter the two contributions are combined in order to obtain the total wind model, S460.

The wind model can then be used in the control of the vessel, for instance when controlling the propulsion of the vessel.

As can be seen above, it is possible to use the draft measurements without load data from the cargo system or load data from the cargo system without draft measurements in both the third and fourth embodiments.

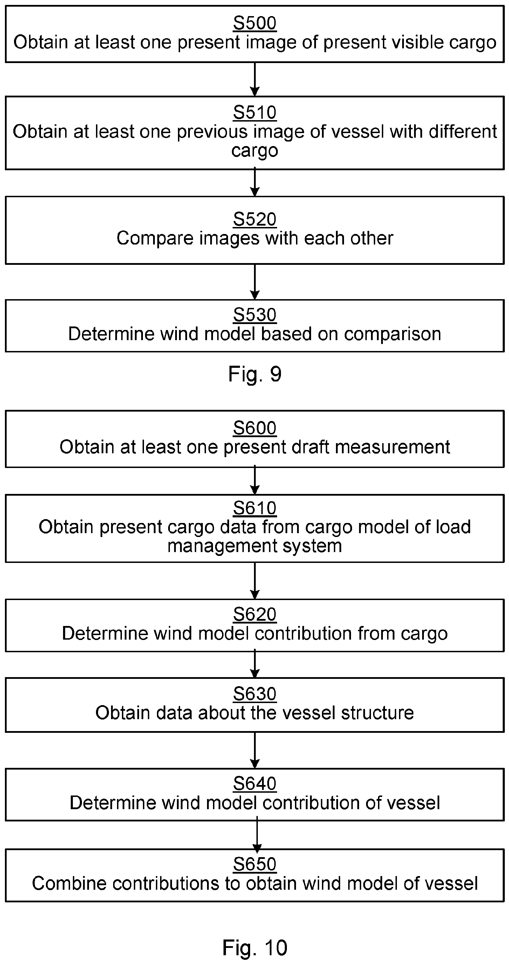

A fifth embodiment will now be described with reference being made to fig. 9.

In this embodiment, the present sensor data again comprises at least one image captured by the at least one image sensor. Again, the vessel 26B uses a load information management system 38. Furthermore, in this embodiment there is a pre-existing wind model for the vessel without cargo.

The method may again start with the wind model determining device obtaining at least one present image of the present visible cargo, S500.

The wind model determining device then obtains at least one previous image of the vessel with a different cargo, S510. The at least one previous image may comprise an image for which there has been detected a vessel behaviour caused by a known wind force acting on the vessel. Alternatively, the at least one previous image may comprise an image of the vessel with a known projected area and a known cargo. The at least one previous image may in this case further be a designed, simulated or model image of different cargo sizes or different trims. The known cargo may for instance be no cargo, a 10% cargo model a 50% cargo model or a 100 % model, a high bow model or a high aft model.

Thereafter the wind model determining device continues and compares the images with each other, S520. The difference between the images may then be indicative of the difference between the wind models.

The determining of the wind model may be based on a difference between the images. Alternatively, the determining of the wind model may be based on a similarity between the images.

The at least one present image may thus be compared with at least one previous image (with the same cargo or with a known relationship to the present cargo) or with a previous image associated with a known vessel behaviour.

A sixth embodiment will now be described with reference being made to fig. 10.

In this case, the wind model determining device 10 may obtain at least one present draft measurement from the draft sensors 32, 34, 36, S600. It may also obtain present cargo data from the cargo model of the load information management system 38, S610, and determine the wind model contribution from the cargo based on the at least one present draft measurement and the present cargo data. The cargo data of the cargo model may be used to determine cargo objects and their sizes as well as the area in the wind directions. The draft measurements may also give an indication of the cargo and its distribution on the vessel.

Alternatively, the draft measurements may be used alone to estimate the wind model contribution from the cargo.

The wind model determining device 10 may also obtain data about the vessel structure and may then determine the wind model contribution of the vessel without cargo based on the draft measurements and the data about the vessel structure.

In this case, a contribution of the present cargo to the present wind model may be determined based on the at least one draft measurement and possibly also on the cargo data and a contribution to the wind model without the present cargo may be determined from the at least one draft measurement and knowledge of the vessel structure.

Thereafter the two contributions are combined in order to obtain the overall or total wind model of the vessel, which may again be used in the operation of the vessel.

The propulsion of the vessel may then be controlled so that the effect on the vessel by the wind is counteracted, which effect may be determined based on the wind model.

It should be understood that projected area is one component in the wind model that has been used as an example. For instance, the wind model determining device can instead work with a more abstract representation of the wind model where present sensor data together with ship motion information is fed into, for example, a machine learning algorithm or artificial intelligence, to directly get a wind model that describes the forces acting on the ship instead of getting the intermediate wind area. This type of approach can also be combined with any other combinations of measurements or previous measurements to get the desired model.

While the invention has been described in connection with what is presently considered to be most practical and preferred embodiments, it is to be understood that the invention is not to be limited to the disclosed embodiments, but on the contrary, is intended to cover various modifications and equivalent arrangements. Therefore, the invention is only to be limited by the following claims.

## Claims

1. A method for the determining of a wind model of a vessel (26B), the method being performed by a wind model determining device (10) and comprising:
obtaining (S100; S200; S300; S400; S500; S600) at least one present sensor measurement of the vessel (26B) when it is carrying a present visible cargo (40, 42), and
determining (S120, S230, S370; S460; S530; S650) at least a part of a wind model of the vessel (26B) based on the at least one present sensor measurement.

2. The method as claimed in claim 1, further comprising obtaining (S110; S220, S350; S450, S510, S640) data related to the vessel (26B) without the present visible cargo (40, 42) and wherein the determining of at least a part of a wind model of the vessel (S120, S230, S370; S460; S510; S650) is also based on said data related to the vessel (26B) without the present visible cargo (40, 42).

3. The method according to claim 2, wherein said data related to the vessel without the present visible cargo (S220; S350; S630) comprises data about the vessel structure.

4. The method according to any of claims 2-3, wherein said data related to the vessel without the present visible cargo (S450) comprises a wind model contribution of the vessel without the present visible cargo.

5. The method as claimed in any previous claim, further comprising obtaining present cargo data (S320; S420; S610) about the present cargo from a cargo model of a load information management system (38) of the vessel, wherein the determining of at least a part of the wind model is based also on the present cargo data of the cargo model.

6. The method as claimed in any previous claim, wherein said at least one present measurement is at least one present image of the vessel.

7. The method as claimed in claim 6, further comprising analysing (S210; S310; S410) the at least one present image in order to determine individual cargo objects (40, 42) and a contribution of these individual cargo objects (40, 42) to the wind model of the vessel (26B).

8. The method as claimed in claim 6 or 7, further comprising obtaining at least one draft sensor measurement (S340) and the determining (S370) of at least a part of the wind model is based also on the at least one draft sensor measurement.

9. The method as claimed in any of claims 6-8 when depending on claim 2, wherein the data related to the vessel without the present visible cargo is at least one previous image of the vessel and further comprising comparing the at least one present image with said at least one previous image of the vessel (S520) and the determining of at least a part of the wind model is based on the comparison of the images (S530).

10. The method as claimed in claim 9, wherein the at least one previous image comprises an image of the vessel (26B) with a known projected area and a known cargo.

11. The method as claimed in claim 9, wherein the at least one previous image comprises an image for which there has been detected a vessel behaviour caused by a known wind force acting on the vessel (26B).

12. The method according to any of claims 1-5 when depending on claim 2, wherein the at least one present sensor measurement is at least one present draft measurement of the vessel (26B) and the data related to the vessel without the present visible cargo comprises data about the vessel structure.

13. A wind model determining device (10) comprising a processor (14) operative to:
obtain at least one present sensor measurement of a vessel (26B) when it is carrying a present visible cargo, and
determine at least a part of a wind model of the vessel (26B) based on the at least one present sensor measurement.

14. A vessel (26B) comprising the wind model determining device (10) according to claim 13.

15. A computer program (18) for the determining of a wind model of a vessel (26B), the computer program (18) comprising computer program code which when run by a processor (14) causes the processor (14) to:
obtain at least one present sensor measurement of the vessel (26B) when it is carrying a present visible cargo (40, 42), and
determine at least a part of a wind model of the vessel based on the at least one present sensor measurement.

16. A computer program product for the determining of a wind model of a vessel (26B), the computer program product comprising a data carrier (24) with said computer program (18) according to claim 15.
